(19) Europäisches Patentamt

European Patent Office

Office européen des brevets

(11) **EP 0 756 156 A2**

(12) **EUROPÄISCHE PATENTANMELDUNG**

(43) Veröffentlichungstag:
**29.01.1997 Patentblatt 1997/05**

(51) Int. Cl.$^6$: **G01D 18/00**

(21) Anmeldenummer: **96112066.4**

(22) Anmeldetag: **26.07.1996**

(84) Benannte Vertragsstaaten:
**AT BE CH DE DK ES FI FR GB GR IE IT LI LU MC NL PT SE**
Benannte Erstreckungsstaaten:
**SI**

(30) Priorität: **28.07.1995 DE 19527588**

(71) Anmelder: **Industrie-Technik Fröschl GmbH**
**93194 Walderbach (DE)**

(72) Erfinder: **Zintl, Peter**
**93092 Friesheim (DE)**

(74) Vertreter: **Graf, Helmut, Dipl.-Ing.**
**Postfach 10 08 26**
**93008 Regensburg (DE)**

(54) **Verfahren zur automatischen Erfassung von Anzeigen von Zählern für Prüf- oder Verrechnungszwecke**

(57)    Die Erfindung bezieht sich auf ein neuartiges Verfahren zur automatischen Erfassung von Anzeigen bei Zählern, insbesondere für Prüf- und/oder Verrech- nungszwecke, wobei die Anzeige an einem ersten Sichtfenster an einer Zählerseite vorgesehen ist.

FIG.1

**Beschreibung**

Die Erfindung bezieht sich auf ein Verfahren zur automatischen Erfassung von Anzeigen von Zählern, insbesondere Stromzählern, für Prüf- oder Verrechnungszwecke gemäß Oberbegriff Patentanspruch 1.

Stromzähler, d.h. Zähler, wie sie üblicherweise zur Messung und Erfassung von elektrischer Energie verwendet werden, aber auch andere Zähler, wie Gaszähler, Wasserzähler, Zähler zur Erfassung des Verbrauchs an Wärmeenergie usw., müssen, sofern sie für den geschäftlichen Verkehr bestimmt sind, für den ersten Gebrauch geeicht werden und nach einer bestimmten Gültigkeitsdauer (Eichgültigkeitsdauer) erneut überprüft bzw. geeicht werden.

Speziell für Elektrozähler sind hierbei neben einer Sicherheits- bzw. Hochspannungprüfung mehrere Prüfschritte vorgeschrieben, nämlich eine sogenannte Leerlaufprüfung, eine Anlaufprüfung, eine Richtigkeitsmessung und eine Zählwerksprüfung bzw. Zählwerkskontrolle.

Die bisher üblichen Prüfverfahren erfordern umfangreiche manuelle Tätigkeiten und sind daher sehr personalintensiv. Da bei den üblichen Prüfverfahren die Anzeigen und Zählerstände vom Bedienungspersonal abgelesen, notiert und/oder in eine Datenerfassungsanlage eingegeben werden müssen, sind die bekannten Prüfverfahren auch nicht frei von Fehlern und Ungenauigkeiten.

Bekannt ist eine Vorrichtung zum Prüfen von Verbrauchszählern, nämlich Wasserzählern (DE-GM 93 20 307). Die bekannte Vorrichtung bildet eine Prüfstrecke, in die der jeweilige Prüfling für Meß- und Eichzwecke eingebaut werden kann. Die Prüfstrecke umfaßt u.a. eine von einem Rechner gesteuerte Einstelleinrichtung zur Einstellung einer vorgegebenen Wasser-Durchflußmenge (in Strömungsrichtung vor dem Prüfling), eine Durchflußmeßeinrichtung (in Strömungsrichtung nach dem Prüfling) und eine Umschalteinrichtung, die auf die Durchflußmeßeinrichtung folgend vorgesehen ist und mit der die Prüfstrecke wahlweise mit einem freien Abfluß oder mit einer Volumenmeßeinrichtung verbunden werden kann. Weiterhin ist eine Druckmeßvorrichtung vorgesehen. Die Messung erfolgt im bekannten Fall so, daß zunächst bei mit dem Abfluß verbundener Prüfstrecke ein vorgegebener konstanter Durchfluß eingestellt wird. Anschließend wird auf die Volumenmeßeinrichtung umgeschaltet. Mit der Videokamera wird der Zählerstand erfaßt und dieser in dem als Bildverarbeitungseinrichtung dienenden Rechner für die Eichprüfung analysiert und ausgewertet. Für eine Richtigkeitsmessung eines Zählers, insbesondere auch eines Zählers zur Messung und Erfassung des Verbrauchs an elektrischer Energie (Stromzähler) mit hoher Genauigkeit ist die bekannte Prüfvorrichtung nicht geeignet.

Bekannt ist weiterhin ein Verfahren zur Überprüfung von Zählern, insbesondere Elektrizitäts-Zählern (DE-A-39 01 816), die ein mechanisches Zählwerk mit einem optischen Signalgeber in Form eines rotierenden Elementes aufweisen. Für die Prüfung wird mittels einer Lichtstrecke, die das rotierende Element des Zählers mit einschließt, ein von der Rotationsgeschwindigkeit dieses Elementes abhängiges elektrisches Signal erzeugt, aus dem dann durch Summenbildung die Durchflußmenge ermittelt wird. Nachteil dieses bekannten Verfahrens ist u.a., daß eine genaue Ausrichtung des Lichtstrahles auf das rotierende Element notwendig ist, was einen zusätzlichen Arbeitsaufwand bedingt und einen automatisch, d.h. mechanisch ablaufenden Prüfvorgang nicht zuläßt.

Aufgabe der Erfindung ist es, ein Verfahren aufzuzeigen, welches die Nachteile des Standes der Technik vermeidet und mit hoher Präzision die Prüfung und dabei insbesondere auch die Richtigkeitsmessung eines Zählers ermöglicht.

Zur Lösung dieser Aufgabe ist ein Verfahren entsprechend dem kennzeichnenden Teil des Patentanspruches 1 ausgeführt.

Bei der Erfindung wird mittels der Videokamera die an einem Sichtfenster des Zählers vorgesehene Änderung des optischen Signalgebers erfaßt, der seinen Zustand entsprechend einem vom Zähler gemessenen Verbrauch periodisch ändert. Dieser Signalgeber ist beispielsweise ein umlaufendes, mit wenigstens einer Markierung versehenes Element, beispielsweise eine Zählerscheibe des Zählers. Dieser Signalgeber kann aber auch beispielsweise eine entsprechend dem gemessenen Verbrauch periodisch aufleuchtende Signallampe oder aber ein anderer optischer Signalgeber sein.

Dadurch, daß bei der Erfindung die Erfassung dieses Signalgebers mittels einer Videokamera erfolgt, ist kein genaues Ausrichten des Zählers notwendig. Dadurch, daß die von der Bildverarbeitungseinrichtung ermittelten periodischen Änderungen des optischen Signalgebers mit Impulsen einer Impulsfolge eines Vergleichszählers verglichen werden, ergibt sich eine hohe Genauigkeit. Bevorzugt erfolgt der Vergleich derart, daß die Anzahl der Impulse des Vergleichszählers gezählt werden, die in eine oder aber in mehrere Perioden der Änderungen des optischen Signalgebers fallen.

Bei dem erfindungsgemäßen Verfahren erfolgt die Erfassung der jeweiligen Anzeige nach Festlegung des relevanten Bildbereiches aus dem von der Video-Kamera gelieferten Bildsignals in der Bildverarbeitungseinrichtung, die aus dem Video-Bild der Anzeige den entsprechenden nummerischen Wert erkennt und einen diesem Wert entsprechenden digitalen Wert für eine Weiterverarbeitung liefert, beispielsweise zum Abspeichern und/oder Ausdrucken und/oder für Vergleichs- und Rechenoperationen usw.

Bevorzugt ist das erfindungsgemäße Verfahren so ausgestaltet, daß bei jedem Prüf- und Meßschritt und dabei vorzugsweise vor jedem Prüf und Meßschritt von der Video-Kamera auch eine den jeweiligen Zähler eindeutig identifizierende Kennung, beispielsweise die Fabrikationsnummer des Zählers erfaßt wird. In der Bildverarbeitungseinrichtung wird dann diese Nummer in entsprechende digitale Kenn-Daten umgewandelt, die dann zusammen mit jedem Meßergebnis gespeichert und/oder der bei mehreren, an einem Zähler durchgeführten Prüfschritten den jeweiligen Einzelergebnissen zugeordnet werden.

Sind mehrere Prüfschritte für jeden Zähler vorgeschrieben, so wird bei jedem Prüfschritt aufgrund der von der Video-Kamera erfaßten Identifikation oder Kenn-Daten auch überprüft, ob der betreffende Zähler bereits vorgeschriebene, vorausgehende Prüfschritte tatsächlich durchlaufen hat. Ist dies nicht der Fall, wird der entsprechende Zähler als nicht vollständig geprüft identifiziert und ausgeschieden, beispielsweise für eine erneute Prüfung.

Weiterbildungen der Erfindung sind Gegenstand der Unteransprüche.

Die Erfindung wird im Folgenden anhand der Figuren an einem Ausführungsbeispiel näher erläutert. Es zeigen:

Fig. 1    in vereinfachter schematischer Darstellung eine Prüfanlage zum vollautomatischen Prüfen und Ablesen von Geräten mit mechanischen Rollen-Zählwerksanzeigen, nämlich zum vollautomatischen Prüfen und Ablesen von Elektrozählern;

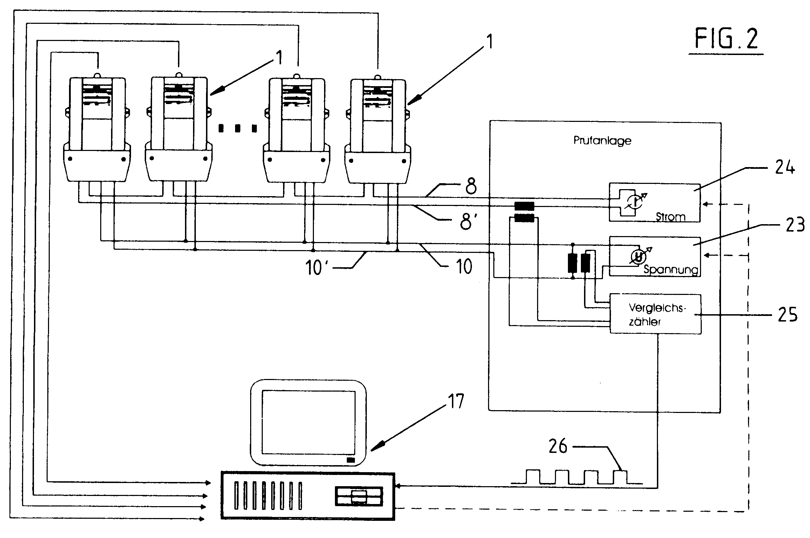

Fig. 2    in vereinfachter schematischer Darstellung ein Detail-Blockschaltbild einer Prüfstation;

Fig. 3    in Teilansicht die Frontseite eines als Ferraris-Zähler ausgebildeten Elektrozählers.

In den Figuren sind 1 Elektrozähler, wie er für die Messung und Erfassung des Verbrauchs an elektrischer Energie üblicherweise verwendet wird und der bei der dargestellten Ausführungsform als Induktions- bzw. Ferraris-Zähler ausgeführt ist und eine von einem Rollenzählwerk 2 gebildete Anzeige aufweist.

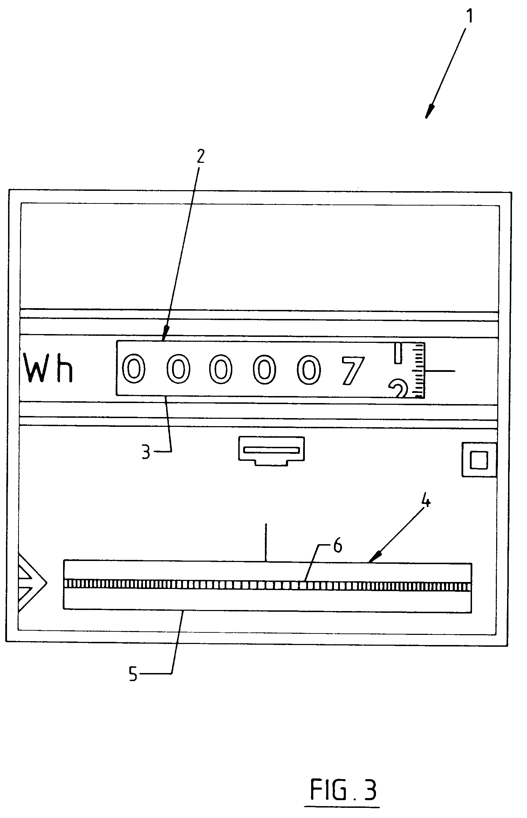

Wie die Fig. 3 zeigt, ist an der Frontseite des Zählers 1 sichtbar die von einem Rollzählwerk 2 gebildete Anzeige, und zwar in einem ersten Sichtfenster 3 sowie der Umfang der Läuferscheibe 4 mit einer Markierung 5 in einem zweiten Sichtfenster 6.

Nach den gültigen gesetzlichen Bestimmungen (Eichgesetz) müssen derartige Zähler 1 ebenso wie die andere Zähler, z.B. Gaszähler, Wasserzähler, Wärmemengenzähler usw. geprüft und geeicht werden, wenn sie für den geschäftlichen Verkehr eingesetzt werden sollen.

Speziell für die Elektrozähler ist ein aufwendiges Prüfverfahren vorgesehen, welche eine Hochspannungsprüfung, eine Leerlaufprüfung, eine Anlaufprüfung, eine Überprüfung der Richtigkeitsmessung sowie eine Zählwerksprüfung umfaßt.

Für die Prüfung sind jeweils mehrere Zähler, beispielsweise eine Gruppe bis zu 160 Zähler auf einem Prüfwagen 7 montiert und mit dort vorhandenen Anschlüssen 8 und 8' für den Strom und Anschlüssen 10 und 10' für die Spannung verbunden, wobei an jedem Zähler 1 bzw. an einem dortigen Klemmenblock die Strom- und Spannungsmeßpfade getrennt sind, so daß der Strommeßpfad eines Zählers 1 jeweils mit einem vorwählbaren Strom und der Spannungsmeßpfad jedes Zählers 1 beaufschlagbar ist.

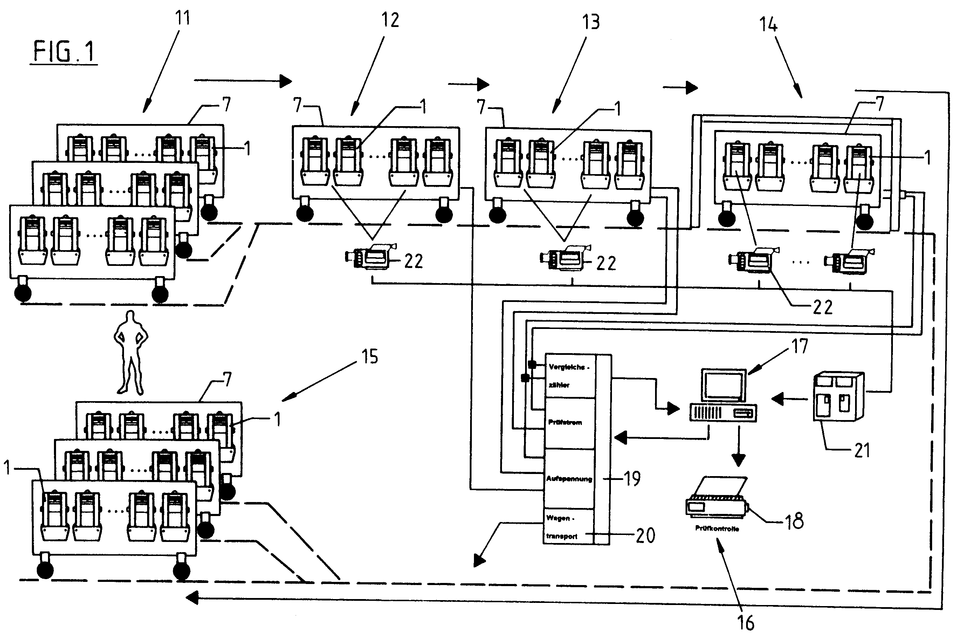

Bei der in der Fig. 1 dargestellten Prüfeinrichtung stehen die mit den zu prüfenden Zählern 1 vorbereiteten Prüfwägen 7 an einer Packstation 11 bereit und werden von dieser Station mit einem mechanischen Transportsystem nacheinander an verschiedenen Prüfstationen vorbeibewegt, nämlich an der Prüfstation 12 für die Hochspannungsprüfung, an der Prüfstation 13 für die Anlaufprüfung und an der an der Prüfstation 14 für die Richtigkeitsmessung und Zählwerkprüfung. Nach der Beendigung der Prüfung werden die Prüfwägen 7 jeweils an eine Station 15 bewegt, an der das Abnehmen der Zähler von den Prüfwägen 7 und das Verpacken der geprüften und geeichten Zähler 1 erfolgt. Von der Station 15 werden die leeren Prüfwägen 7 an die Station 11 zurückgebracht, an der dann erneut das Bestücken dieser Prüfwägen mit den Prüflingen bzw. Zählern 1 erfolgt.

Die Bewegung der Prüfwägen 7 von der Parkstation über die einzelnen Prüfstationen an die Parkstation 15 und von dieser zurück an die Parkstation 11 erfolgt durch das Transportsystem, welches vorzugsweise durch eine zentrale Steuereinrichtung 20 gesteuert ist. Der gesamte Prüfablauf mit Ausnahme des Bestückens der Prüfwägen 7 und des Abnehmens der Zähler 1 von diesen Prüfwägen kann bedienerlos, d.h. automatisch, beispielsweise im Nachtbetrieb erfolgen, so daß es auch möglich ist, während des Tages eine Vielzahl von Prüfwägen 7 mit Zählern 1 zu bestücken und die Prüfung der Zähler dann nachts durchzuführen.

Die Erfassung, Verarbeitung und Speicherung aller für die Prüfung relevanten Daten sowie deren Protokollierung erfolgt durch ein zentrales Meß- und Steuersystem 16, welches bei der dargestellten Ausführungsform einen Rechner 17 mit peripheren Geräten umfaßt, und zwar mit einem Drucker 18, mit einer Prüfanlage 19, mit der Steuereinrichtung 20 zur Steuerung des Transportes der Prüfwägen 7 sowie mit einer Bildverarbeitungseinrichtung 21, die mit einer Vielzahl von an den einzelnen Prüfstationen 12 - 14 vorgesehenen Video-Kameras zusammenwirkt.

Für die Hochspannungsprüfung werden die Zähler 1 an der Prüfstation 12 mit ihren Anschlüssen mit einer vorgegebenen Spannung, d.h. mit einer Spannung von 2 kV gegen Erdpotential beaufschlagt. Bei dieser Prüfung wird zusätzlich zu einer elektrischen Erfassung des Prüfergebnisses jeder Zähler 1 mit einer Kamera 22 erfaßt und die Bildverarbeitungseinrichtung 21 liefert ein entsprechendes Fehlersignal an den zentralen Rechner 17, wenn bei dieser Hochspannungsprüfung im bzw. am Zähler sichtbare Entladungen oder Spannungsüberschläge auftreten.

Bei der Leerlaufprüfung wird jeder Zähler 1 mit Energie dosiert so beaufschlagt, bis die Markierung 5 an der Läuferscheibe 4 in der Mitte des Sichtfensters 6 erscheint. Ist dies der Fall, wird die Energie vom Zähler abgeschaltet. Dies erfolgt gesteuert durch die Bildverarbeitungseinrichtung 21 aufgrund des Signals einer den jeweiligen Zähler erfassenden Video-Kamera 22, und zwar beispielsweise durch einen Bildvergleich in der Bildverarbeitungseinrichtung 21.

Jeder Zähler 1 wird dann anschließendstromlos über die Anschlüsse 10 und 10' mit einer Prüf-Spannung beaufschlagt, die dem 1,1-fachen der Nennspannung entspricht ($U = 1,1 U_{nenn}$ und $I = 0_A$). Die Läuferscheibe 4 bzw. die dortige Markierung 5 wird weiterhin von der Video-Kamera 22 und der Bildverarbeitungseinrichtung 21 erfaßt. Bei dieser Leerlaufprüfung, die anschließend auch mit einer Spannung, die 90% der Nennspannung entspricht, wiederholt wird, darf sich die Läuferscheibe 4 über eine angemessene Zeit nicht weiterdrehen.

Ebenso wie die Leerlaufprüfung erfolgt in der Prüfstation 13 auch die Anlaufprüfung. Hierbei wird jeder geprüfte Zähler 1 wiederum von einer der Video-Kameras 22 erfaßt. Die Zähler werden jeweils mit der Nennspannung und mit 5% des Nennstromes beaufschlagt. Innerhalb einer vorgegebenen Zeit muß jeder Zähler 1 sicher anlaufen. Dieses Kriterium gilt als erfüllt, wenn innerhalb einer vorgegebenen Zeit sich die Markierung 5 aus dem Sichtfenster 6 herausbewegt hat. Auch dies wird wiederum mit Hilfe der Bildverarbeitungseinrichtung 21 und der den Zähler 1 erfassenden Video-Kamera 22 beispielsweise durch Bildvergleich ermittelt und als entsprechendes Prüfergebnis an den Rechner 17 übertragen.

An der Prüfstation 14 werden dann an jedem Zähler die Richtigkeitsmessung und die Zählwerksprüfung durchgeführt. Bei der Richtigkeitsprüfung wird der jeweilige Meßfehler des Zählers 1 in definierten Betriebspunkten ermittelt und in einem Prüfprotokoll dokumentiert, und zwar zusammen mit der zur Identifikation des Zählers dienenden Fabriknummer, die ebenso, wie andere Kriterien über die an der Prüfstation 14 ebenfalls vorgesehenen Video-Kameras 22 und die Bildverarbeitungseinrichtung 21 erfaßt werden.

Bei der Richtigkeitsmessung wird jeder Zähler mit einer definierten Prüf-Leistung geprüft, d.h. hierfür werden die an dem betreffenden Prüfwagen 7 vorgesehenen Zähler 1 über die Leitungen 10 und 11 mit einer vorgegebenen Spannung, d.h. mit der Nennspannung beaufschlagt, und zwar von einer Meßspannungsquelle 23, und über die Leitungen 8 und 8' mit einem vorgegebenen Strom, und zwar aus einer Stromquelle 24 der Prüfanlage 19. Parallel hierzu liegt die Leistung an einem Vergleichszähler 25, der als Präzisionszähler ausgeführt ist und der eine Impulsfolge mit Impulsen 26 ausgibt, bei der die Anzahl der Impulse pro Zeiteinheit proportional zur Prüf-Leistung ist.

Bei definierter Leistung ergibt sich für jeden Zähler 1 eine Soll-Zeit für eine volle Umdrehung der Läuferscheibe 4. Die Umdrehung der jeweiligen Läuferscheibe 4 wird mit Hilfe der an der Prüfstation 14 vorgesehenen Video-Kameras 22 und der Bilderkennungseinrichtung 21 überwacht, wobei die Bilderkennungseinrichtung 21 beispielsweise jeweils bei jeder vollen Umdrehung der Läuferscheibe 4 eines in der Prüfung befindlichen Zählers 1 für diesen Zähler einen Meßimpuls an den Rechner 17 liefert. Dieser ermittelt dann aus der Anzahl der Impulse 26, die zwischen zwei Meßimpulsen oder einer anderen, vorgegebenen Anzahl von Meßimpulsen auftreten, den Meßfehler des jeweiligen Zählers, und zwar wie folgt:

Meßfehler = [Soll-Zahl der Impulse - Ist-Zahl der Imulse] /Ist-Zahl der Impulse x 100(%).

Die Ist-Zahl der Impulse 26 ist dabei die tatsächlich in dem Intervall zwischen zwei oder mehreren Meßimpulsen anfallende Anzahl der Impulse 26.

Die Soll-Impulszahl ist dabei die theoretisch errechnete, zwischen zwei oder mehreren Meßimpulsen anfallende Anzahl von Impulsen 26.

Die Zählwerkskontrolle, die ebenfalls in der Prüfstation 14 an jeden an dem dortigen Prüfwagen 7 vorgesehenen Zähler 1 durchgeführt wird, dient dazu, die Genauigkeit des Zählwerkes, d.h. bei den als Ferraris-Zähler ausgebildeten Zählern 1 die Übersetzung der Drehbewegung der Läuferscheibe 4 auf das mechanische Rollenzählwerk 2 zu prüfen. Hierfür wird der jeweilige aktuelle Stand des Zählwerkes 2 erfaßt und in die Prüfanlage 19 eingegeben, was wiederum über die den jeweiligen Zähler erfassende Video-Kamera 22, die Bildverarbeitungseinrichtung 21 und den Rechner 17 erfolgt. Nach Registrierung des aktuellen Standes für sämtliche Zähler 1 werden diese, veranlaßt durch den Rechner 17, durch die Prüfanlage 19 mit einer genau definierten Energiemenge, beispielsweise mit einer Prüfenergie von 3 kWh beaufschlagt. Im Anschluß daran wird die Anzeige des Zählwerkes 2 jedes Zählers 1 wiederum von der Video-Kamera 22 erfaßt und der neue Stand des Zählwerkes jedes Zählers mit der Bilderkennungseinrichtung ermittelt und an den Rechner 17 übertragen. Der Rechner 17 ermittelt dann für jeden Zähler 1 die Differenz der beiden Zählwerksstände, die (Differenz) der Prüfenergie entsprechen muß, und diese Differenz in dem Protokoll für den jeweiligen Zähler dokumentiert.

Das Erfassen der einzelnen Zähler 1 an den Prüfstationen 12 - 14 erfolgt mit den dortigen Video-Kameras 22 jeweils in einem vorgegebenen Zyklus zeitlich nacheinander. An den Prüfstationen ist für jeden Zähler 1 bzw. für jede mit einem zu prüfenden Zähler zu besetzende Prüf-Position des Prüfwagens 7 jeweils eine Video-Kamera 22 vorgesehen, oder aber eine Video-Kamera 22 für eine vorgegebene Anzahl oder Gruppe von Zählern 1 oder Prüfplätzen. Hierbei werden dann durch Relativbewegung zwischen der Video-Kamera 22 und dem Prüfwagen 7 sämtliche einer Video-Kamera zugeordneten Zähler oder Prüfplätze von dieser erfaßt.

Die Bildverarbeitungseinrichtung ist so ausgeführt, daß sie vor jeder Prüfung zunächst den für die Prüfung relevanten Bildbereich ermittelt, d.h. für die Leerlaufprüfung, Anlaufprüfung und Richtigkeitsprüfung den durch das Sichtfenster 6 bestimmten Bildbereich und für die Zählwerkskontrolle den durch das Sichtfenster 3 bestimmten Bildbereich. Eine spezielle Software der Bildverarbeitungseinrichtung 21 interpretiert den jeweiligen Bildbereich und ermittelt bei der Zählwerkskontrolle den nummerischen Wert, der der im Bild vorliegenden und von dem Zählwerk 2 am Sichtfenster 3 angezeigten Zahl entspricht.

Die Bildverarbeitungseinrichtung 21 ist vorzugsweise mikroprozessor-gestützt augeführt, d.h. diese Einrichtung besitzt einen eigenen Mikroprozessor, der die Bildauswertung und/oder -verarbeitung nach einer Bildverarbeitungs-Software ausführt.

Die Bildverarbeitungseinrichtung 21 bzw. deren Software ist so ausgeführt, daß für den Bediener die interaktive Einrichtung eines neuen Zählers möglich ist. Ebenso können neue Fonds in das System eingelernt werden. Ein spezieller Algorithmus sorgt für die sichere Auswertung auch von Zwischenständen bei der Anzeige des Zählwerkes 2. Weiterhin verfügt das Bildverarbeitungsprogramm über eine Kommando-Schnittstelle und kann somit leicht in unterschiedliche Applikationen integriert werden.

Für die Dokumentation wird zu jedem Zähler 1 auf dem zugehörigen Protokoll das nach dem letzten Prüfschritt durch die entsprechende Video-Kamera 22 erfaßte Bild gedruckt und archiviert.

Vorteile des vorbeschriebenen Prüfsystems lassen sich, wie folgt, zusammenfassen:

Automatische, bedienerlose Abläufe.

Eine zeitaufwendige und fehlerbehaftete manuelle Erfassung von Anzeigen und Angaben entfällt.

Eine Einstellung von Abtastköpfen beispielsweise zum Abtasten der Läuferscheibe 4 entfällt, da die Video-Kameras in Verbindung mit dem Bildverarbeitungssystem 21 eine genaue Justage nicht erfordern.

Es lassen sich wesentlich höhere Maschinenlaufzeiten (auch Nachtbetrieb) erreichen.

Es wird ein Fehlerprotokoll mit Bild möglich, welches eine wesentlich höhere Aussagekraft hat als reine nummerische Werte.

Die Erfindung wurde voranstehend an einem Ausführungsbeispiel beschrieben. Es versteht sich, daß zahlreiche Änderungen sowie Abwandlungen möglich sind, ohne daß dadurch der der Erfindung zugrundeliegende Erfindungsgedanke verlassen wird. So ist beispielsweise die Erfindung nicht nur anwendbar bei Stromzählern, sondern auch bei anderen Zählern, beispielsweise bei Gas-, Wasser- und Wärmezählern. Weiterhin ist die Erfindung nicht nur anwendbar bei der Prüfung solcher Zähler, sondern auch für die Justage von Zählern sowie für die Ablesung von Zählern für die Verrechnung.

### Bezugszeichenliste

| 1 | Zähler |
|---|---|
| 2 | Zählwerk |
| 3 | Sichtfenster |
| 4 | Läuferscheibe |
| 5 | Markierung |
| 6 | Sichtfenster |
| 7 | Prüfwagen |
| 8, 8', 10, 10' | Leitung |
| 11 | Parkstation |
| 12 - 14 | Prüfstation |
| 15 | Parkstation |
| 16 | zentrales System |
| 17 | Rechner |
| 18 | Drucker |
| 19 | Prüfanlage |
| 20 | Steuereinrichtung |
| 21 | Bildverarbeitungseinrichtung |
| 22 | Video-Kamera |
| 23 | Spannungsquelle |
| 24 | Stromquelle |
| 25 | Vergleichszähler |
| 26 | Impuls |

### Patentansprüche

1. Verfahren zum Prüfen von Zählern mit Anzeigen, die jeweils an wenigstens einem Sichtfenster (3, 6) an einer Zählerseite vorgesehen sind, wobei mit einer wenigstens eine Videokamera (22) aufweisenden Bildverarbeitungseinrichtung (21) zunächst der das Sichtfenster (3, 6) aufweisende relevante Bildbereich ermittelt, anschließend die Anzeige optisch erfaßt und durch Bildverarbeitung in ein durch einen Rechner verarbeitbares Signal umgesetzt wird, wobei von der mit der Bildverarbeitung (21) zusammenwirkenden Video-Kamera (22) ein am Zähler vorgesehener optischer Signalgeber erfaßt wird, der seine Lage oder seinen Zustand periodisch in Abhängigkeit von dem vom Zähler gemessenen Verbrauch ändert, und wobei für eine Richtigkeitsmessung des Zählers dieser mit einem vorgegebenen Verbrauch (Prüfgröße) beaufschlagt wird, **dadurch gekennzeichnet**, daß die von der Bildverarbeitungseinrichtung ermittelten periodischen Änderungen des optischen Signalgebers mit Impulsen einer Impulsfolge oder eines Impulssignals (Vergleichssignal) verglichen werden, die von einem geeichten und mit der gleichen Prüfgröße beaufschlagten Vergleichszähler geliefert werden und deren Impulsfolgefrequenz abhängig von der Prüfgröße ist.

2. Verfahren nach Anspruch 1, dadurch gekennzeichnet, daß für den Vergleich in der Bildverarbeitungseinrichtung oder in einem an diese angeschlossenen Rechner (17) diejenige Anzahl der Impulse des Impulssignals des Vergleichszählers gezählt wird, die innerhalb einer oder mehrerer der periodischen Zustandsänderungen des optischen Signalgebers anfallen.

3. Verfahren nach Anspruch 1 oder 2, dadurch gekennzeichnet, daß die Anzahl der Impulse des Impulssignals des Vergleichszählers innerhalb einer oder mehrerer der periodischen Zustandsänderungen des optischen Signalgebers (4) eine Ist-Impulszahl bildet, die mit einer Soll-Impulszahl verglichen wird.

4. Verfahren nach einem der vorhergehenden Ansprüche, dadurch gekennzeichnet, daß von der Bildverarbeitungseinheit (21), die auch einen numerischen Wert der in dem relevanten Bildbereich vorliegenden Zahl der Anzeige durch Bildverarbeitung ermittelt, für eine Richtigkeitsprüfung der Anzeige eines Zählers zunächst aus einem Anfangszustand der Anzeige den entsprechenden numerischen Wert ermittelt, daß der Zähler dann mit einem Verbrauch vorgegebener Größe (Prüfgröße) beaufschlagt wird, daß im Anschluß daran der dem Endzustand der Anzeige entsprechende numerische Wert von der Bildverarbeitungseinheit (21) ermittelt wird, und daß beide Werte ausgedruckt und/oder gespeichert werden,
wobei vorzugsweise beide numerischen Werte zusammen mit der Prüfgröße und/oder zusammen mit der Differenz der beiden numerischen Werte und/oder zusammen mit der Abweichung dieser Differenz von der Prüfgröße ausgedruckt und/oder gespeichert werden.

5. Verfahren nach einem der vorhergehenden Ansprüche, dadurch gekennzeichnet, daß die Ermittlung des relevanten Bildbereichs und/oder des Wertes oder der Bedeutung der Anzeige in der Bildverarbeitungseinheit durch Vergleich des von der Video-Kamera (22) erfaßten Bildes mit in der Bildverarbeitungseinrichtung (21) gespeicherten Bildern erfolgt.

6. Verfahren nach einem der vorhergehenden Ansprüche, dadurch gekennzeichnet, daß bei einer mehr als zweistelligen Anzeige der relevante Bildbereich lediglich die beiden letzten Stellen dieser Anzeige bildet.

7. Verfahren nach einem der vorhergehenden Ansprüche, dadurch gekennzeichnet, daß der optische Signalgeber des Zählers für eine Leerlaufprüfung oder eine Anlaufprüfung von der mit der Bildverarbeitungseinrichtung (21) zusammenwirkenden Video-Kamera (22) erfaßt, und daß von der Bidlverarbeitungseinrichtung (21) bei dieser Prüfung auftretende Änderungen des Zustandes des optischen Signalgebers im Bild erkannt und in der Bildverarbeitungseinrichtung (21) oder in dem an diese angeschlossenen Rechner (17) registriert werden.

8. Verfahren nach einem der Ansprüche 1 - 8, dadurch gekennzeichnet, daß bei jedem Prüf- oder Meßschritt von der mit der Video-Kamera zusammenwirkenden Bildverarbeitungseinrichtung (21) zugleich auch eine den jeweiligen Zähler (1) charakterisierende Kennung erfaßt wird.

9. Verfahren nach einem der vorhergehenden Ansprüche, dadurch gekennzeichnet, daß die Zähler (1) für jeden Prüf- und/oder Meßschritt als mehrere solche Zähler umfassende Gruppe jeweils an vorgegebenen Meßplätzen eines Prüfwagens (7) vorgesehen sind, daß jeder Prüfwagen (7) zum Messen und/oder Prüfen jeweils an wenigstens einer Prüfstation (12 - 14) bewegt wird,
wobei vorzugsweise an der wenigstens einen Prüfstation (12 - 14) wenigstens eine Video-Kamera (22) vorgesehen ist, mit der jeweils wenigstens ein Meßplatz erfaßt wird oder die vorzugsweise für eine mehrere Zähler (1) aufweisende Untergruppe gemeinsam ist, und daß das Prüfen und/oder Messen sämtlicher Zähler an dem Prüfwagen (7) durch Relativbewegung zwischen dem Meßwagen (7) und der wenigstens einen Video-Kamera (22) folgt.

10. Verfahren nach einem der vorhergehenden Ansprüche, dadurch gekennzeichnet, daß an der wenigstens einen Prüfstation (12 - 14) für jeden Meß- oder Prüfplatz eine eigene Video-Kamera (22) verwendet ist.

11. Verfahren nach einem der Ansprüche 1 - 12, dadurch gekennzeichnet, daß die mit den Zählern (1) vorbestückten Prüfwägen (7) durch ein mechanisches Transportsystem von einer Parkstation (11) an die wenigstens eine Prüfstation (12 - 14) und von dieser zurück an eine Parkstation (15) zum Abnehmen der geprüften Zähler von den Prüfwägen (7) und zum Bestücken der Prüfwägen (7) mit zu prüfenden Zählern (1) bewegt werden.

FIG.1

FIG.2

EP 0 756 156 A2

Wh

0 0 0 0 0 7

FIG. 3